(19) Europäisches Patentamt
European Patent Office
Office européen des brevets

(11) **EP 1 840 263 A1**

(12) **EUROPEAN PATENT APPLICATION**
published in accordance with Art. 158(3) EPC

(43) Date of publication:
03.10.2007 Bulletin 2007/40

(51) Int Cl.:
*D21H 13/22* (2006.01)   *D01F 6/76* (2006.01)

(21) Application number: 06711716.8

(22) Date of filing: 16.01.2006

(86) International application number:
PCT/JP2006/300435

(87) International publication number:
WO 2006/077789 (27.07.2006 Gazette 2006/30)

(84) Designated Contracting States:
DE GB

(30) Priority: 18.01.2005 JP 2005010560
18.01.2005 JP 2005010573
25.01.2005 JP 2005017082
27.01.2005 JP 2005019556

(71) Applicant: Asahi Kasei Chemicals Corporation
Tokyo 100-8440 (JP)

(72) Inventors:
• SHIRATORI, Naoyuki
Tokyo, 1008440 (JP)
• HIGUCHI, Masao
Tokyo, 1008440 (JP)
• MATSUSHITA, Fumio
Tokyo, 1008440 (JP)

(74) Representative: HOFFMANN EITLE
Patent- und Rechtsanwälte
Arabellastrasse 4
81925 München (DE)

(54) **POLYKETONE FIBER PAPER, POLYKETONE FIBER PAPER CORE MATERIAL FOR PRINTED WIRING BOARD AND PRINTED WIRING BOARD**

(57) An aliphatic polyketone fiber paper comprising aliphatic polyketone fibers and a polyketone fiber paper core material for a printed wiring board are provided. The polyketone fiber paper and the core material have high strength and modulus of elasticity; excellent dimensional stability, chemical resistance, heat resistance, adhesiveness and electrical insulation; and low dielectricity and water absorbance, and are thin, porous, and uniform. A printed wiring board prepared from the core material having a low dielectric constant, dimensional stability, electrical insulation, and properties of being uniformly bored by laser punching is also provided. The aliphatic polyketone fiber paper and the core material for a printed wiring board comprises 1 to 100% by mass of aliphatic polyketone fibers which comprise the repeating unit of the below-mentioned formula (1), the fibers having an average fiber length of 0.5 to 10 mm, an average fiber diameter of 0.1 to 20 $\mu$m, a thickness of 5 to 200 $\mu$m, a void ratio of 30 to 90%, and a strength per unit mass of 100 MN/kg or more. Also provided is a single layer or multilayer printed wiring board which comprises a core material impregnated or coated with a polymer resin, a low dielectric polymer resin, or a polyphenylene ether-based epoxy resin.

$$-CH_2-CH_2-CO- \qquad (1)$$

EP 1 840 263 A1

**Description**

TECHNICAL FIELD

The present invention relates to a polyketone fiber paper which comprises 1 to 100% by mass of aliphatic polyketone fibers and which is obtained by a wet paper making process, a polyketone fiber paper core material for a printed wiring board, and a printed wiring board using the polyketone fiber paper core material.

More particularly, the present invention relates to a polyketone fiber paper which comprises aliphatic polyketone fibers, which has high strength and modulus of elasticity; excellent dimensional stability, chemical resistance, heat resistance, adhesiveness, and electrical insulation; and low dielectricity and water absorbance, and which is light, thin, and porous with uniform pores, a polyketone fiber paper core material for a printed wiring board, and a printed wiring board using the polyketone fiber paper core material.

BACKGROUND ART

In recent years, the manufacture of synthetic fiber paper using synthetic fibers instead of wood pulp has been studied. Synthetic fiber paper has good water resistance combined with the various properties of the synthetic fibers. Thus, synthetic fiber paper has received attention as a new material and various types have been proposed.

For example, a fiber paper using polyester fibers is disclosed in Patent Document 1. This has excellent water resistance and chemical resistance. Thus, it is used in supports for printing plates of heat-sensitive stencils. However, it is necessary to improve heat resistance since polyester fibers are a thermoplastic resin and dimensional stability and strength are reduced by thermal expansion when exposed to a high temperature.

Also, a fiber paper using aromatic polyamide fibers is disclosed in Patent Document 2. This fiber paper has excellent mechanical strength, dimensional stability, heat resistance, and the like. Thus, the fiber paper is used in substrates for multilayer printed wiring boards. However, since aromatic polyamide fibers have high water absorbance, the printed wiring board substrates made from the aromatic polyamide fibers swell by desorption of the absorbed water during processing at a high temperature. Thus, there is room for improvement. In addition, the aromatic polyamide fibers are desired to possess improved performance in adhesion with other resins.

A sheet-like product using aliphatic polyketone fibers is disclosed in Patent Document 3. Although it is disclosed that the sheet-like structure material has low water absorbance, is highly rigid, and has chemical resistance, mechanical strength, dimensional stability, heat resistance, and adhesiveness, there is still room for improvement.

Although it is disclosed in Patent Document 4 that a polyketone nonwoven fabric having a thickness of 50 to 200 $\mu$m is applied to a battery separator and exhibits excellent electrolyte infinity, there is still room for improvement.

Synthetic fiber paper also has excellent electrical insulation. Thus, use thereof in electrical materials, in particular, substrates of printed wiring boards (core material) and the like is being studied.

With progression in the miniaturization and high integration of electronic devices, the slimming and multilayering of printed wiring boards are desired.

In multilayer printed wiring boards, slimming is difficult when the core material is thick. If the core material is thin, printed wiring boards are easily deformed and have poor dimensional stability. Also, when the core material has high water absorbance, there is trouble such as the occurrence of swelling and/or damage to the electrical insulation of the substrate when immersed in a molten solder bath. Furthermore, when adhesion of the core material and the thermoplastic resin or thermosetting resin impregnated into or applied to the core material is bad, the impact resistance of the substrate is inferior.

When a fiber paper using aromatic polyamide fibers is used as the core material for a multilayer printed wiring board, an improvement in low water absorbance and high adhesiveness is desired. Also, when a fiber paper comprising polyester fibers is used, the multilayer printed wiring board is easily deformed since the modulus of elasticity is low. Thus, there is room for improvement in dimensional stability. When a glass woven fabric or a glass nonwoven fabric is used, there are limitations in its application to uses desiring high frequency characteristics since the dielectric constant of glass is high. However, a polyketone fiber paper core material and a printed wiring board using a polyketone fiber paper are still not on the market.

(Patent Document 1) Japanese Patent Application No. 2003-171191
(Patent Document 2) Japanese Patent Application Laid-open No. H08-190326
(Patent Document 3) Japanese Patent Application Laid-open No. 2001-207335
(Patent Document 4) Japanese Patent Application No. 2004-10408

## DISCLOSURE OF THE INVENTION

Problems to be Solved by the Invention

The present invention solves the above-mentioned problems seen in the prior art. Specifically, an object of the present invention is to provide an aliphatic polyketone fiber paper which comprises 1 to 100% by mass of aliphatic polyketone fibers, which has high strength and modulus of elasticity; excellent dimensional stability, chemical resistance, heat resistance, adhesiveness and electrical insulation; and low dielectricity and water absorbance, and which is light, thin, porous, and uniform.

Another object of the present invention is to provide a polyketone fiber paper core material for a printed wiring board which has excellent heat resistance, adhesiveness, and chemical resistance; low dielectricity and water absorbance; and high modulus of elasticity, and which is light, thin, porous and uniform, and also to provide a printed wiring board which uses a fiber paper comprising aliphatic polyketone fibers as the core material and which has low dielectricity, and excellent dimensional stability and electrical insulation.

Means for Solving the Problems

In order to achieve the above objects, the inventors of the present invention have conducted extensive studies on fiber papers comprising aliphatic polyketone fibers. As a result, the inventors have found that an aliphatic polyketone fiber paper exhibiting excellent chemical resistance, heat resistance, dimensional stability, adhesiveness, and electrical insulation; having low dielectricity and water absorbance, high strength and modulus of elasticity; and being light, thin, porous and uniform can be brought to fruition.

The inventors have further found that a polyketone fiber paper core material for a printed wiring board which has excellent heat resistance, adhesiveness, and chemical resistance; low dielectricity and water absorbance; and high modulus of elasticity, and which is light, thin, porous and uniform can be brought to fruition, and that a printed wiring board which uses a fiber paper comprising aliphatic polyketone fibers and which has low dielectricity and excellent dimensional stability and electrical insulation can be brought to fruition. These findings have led to the completion of the invention.

Specifically, the present invention provides:

1. A polyketone fiber paper comprising 1 to 100% by mass of aliphatic polyketone fibers which comprise the repeating unit of the following formula (1), wherein the polyketone fiber paper is produced by a wet process.

$$-CH_2-CH_2-CO- \qquad (1)$$

2. A polyketone fiber paper comprising 1 to 99% by mass of aliphatic polyketone fibers which comprise the repeating unit of the following formula (1), wherein the polyketone fiber paper is produced by a wet process.

$$-CH_2-CH_2-CO- \qquad (1)$$

3. A polyketone fiber paper comprising aliphatic polyketone fibers which comprise the repeating unit of the following formula (1), wherein the polyketone fiber paper is produced by a wet process.

$$-CH_2-CH_2-CO- \qquad (1)$$

4. The polyketone fiber paper according to any one of 1 to 3 above having a thickness of 5 to 200 $\mu$m.

5. The polyketone fiber paper according to any one of 1 to 3 above having a thickness of 5 to 100 μm.

6. The polyketone fiber paper according to any one of 1 to 3 above having a thickness of 5 to 50 μm.

7. The polyketone fiber paper according to any one of 1 to 6 above, having a void ratio shown by the following formula of 30 to 90%.

$$\text{Void ratio} = (1 - \text{total mass of fibers forming the fiber paper/density of}$$

$$\text{the fibers/(thickness of fiber paper} \times \text{area of fiber paper})) \times 100$$

8. The polyketone fiber paper according to any one of 1 to 7 above, wherein the strength per unit mass of the fiber paper is 100 MN/kg or more, wherein the strength per unit mass is tensile strength/thickness/basis weight.

9. The polyketone fiber paper according to any one of 1 to 7 above, wherein the strength per unit mass of the fiber paper is 200 MN/kg or more, wherein the strength per unit mass is tensile strength/thickness/basis weight.

10. The polyketone fiber paper according to any one of 1 to 7 above, wherein the strength per unit mass of the fiber paper is 400 MN/kg or more, wherein the strength per unit mass is tensile strength/thickness/basis weight.

11. The polyketone fiber paper according to any one of 1 to 10 above, wherein the aliphatic polyketone fibers are staple fibers having an average fiber length of 0.5 to 10 mm.

12. The polyketone fiber paper according to any one of 1 to 11 above, wherein the aliphatic polyketone fibers have an average fiber diameter of 0.1 to 20 μm.

13. A polyketone fiber paper core material for a printed wiring board comprising the polyketone fiber paper according to any one of 1 to 12 above.

14. The polyketone fiber paper core material for a printed wiring board according to 13 above, wherein the polyketone fiber paper is used in a single layer or multiple layers.

15. A printed wiring board comprising the polyketone fiber paper core material according to any one of 13 to 14 above and a polymer resin.

16. A printed wiring board comprising a polyketone fiber paper core material impregnated or coated with a polymer resin.

17. The printed wiring board according to any one of 15 to 16 above, wherein the polymer resin is a low dielectric polymer resin.

18. The printed wiring board according to any one of 15 to 17 above, wherein the polymer resin is a polyphenylene ether-based epoxy resin comprising polyphenylene ether substituted with or containing an epoxy group in an average amount of one or more per molecule and at least one curing agent selected from the group consisting of an amine, a novolak phenol, and an acid anhydride as essential components.

19. The printed wiring board according to any one of 1 to 18 above, comprising the printed wiring board of a single layer or multiple layers.

20. A method for producing an aliphatic polyketone fiber paper comprising preliminarily refining aliphatic polyketone fibers, crushing the refined aliphatic polyketone fibers, and making paper from the crushed aliphatic polyketone fibers.
21. The method for producing an aliphatic polyketone fiber paper according to 20 above, wherein the preliminary refining comprises a treatment using a beater or a refiner.

22. The method for producing an aliphatic polyketone fiber paper according to 20 above, wherein the crushing comprises a treatment using a high pressure homogenizer.

EFFECT OF THE INVENTION

The polyketone fiber paper of the present invention provides a fiber paper having high strength and modulus of elasticity; dimensional stability, heat resistance, and chemical resistance; low dielectricity and water absorbance; high electrical insulation; and excellent adhesiveness, and being light, very thin, porous, and uniform. Thus, the polyketone fiber paper has a prominent effect of having features which have not been possessed by any known materials.
The polyketone fiber paper core material for a printed wiring board of the present invention provides a light, very thin, and porous core material, which has low dielectricity, high strength and modulus of elasticity, excellent heat resistance, chemical resistance, low water absorbance, and excellent adhesiveness. In addition, the printed wiring board using the aliphatic polyketone fiber paper as a core material is light and thin and excels in low dielectricity, dimensional stability, impact resistance, electrical insulation, and properties of being uniformly bored by laser punching. Thus, the printed wiring board has a prominent effect of having features which have not been possessed by any known printed wiring board.

BEST MODE FOR CARRYING OUT THE INVENTION

The present invention is described below in detail.
The polyketone fiber paper of the present invention is a fiber paper produced by a wet process comprising 1 to 100% by mass of aliphatic polyketone fibers. The polyketone fiber paper rapidly softens and deforms near the melting point of the aliphatic polyketone fibers. The polyketone fiber paper of the present invention makes use of these properties and is characterized in which aliphatic polyketone fibers thermally fused among themselves or with other fibers. Furthermore, the method described herein can produce a uniform and tough fiber paper, notwithstanding its lightness, thinness, and porosity.
The polyketone fiber paper core material for a printed wiring board of the present invention contains the polyketone fiber paper of the present invention.
The polyketone fiber paper core material for a printed wiring board of the present invention may either consist only of the polyketone fiber paper of the present invention or contain other components necessary as a core material for a printed wiring board.

The thickness of the fiber paper of the present invention is preferably from 5 to 200 $\mu$m, more preferably from 5 to 100 $\mu$m, more preferably from 5 to 90 $\mu$m, more preferably from 5 to 50 $\mu$m, more preferably from 5 to 40 $\mu$m, more preferably from 5 to 20 $\mu$m, and still more preferably from 5 to 15 $\mu$m. The fiber paper with a thickness of 5 to 200 $\mu$m can be handled in the same manner as commonly used paper. Such a fiber paper is soft and can be variously processed, and the formed products can be easily deformed and cut. In addition, the fiber paper exhibits excellent air permeability, impregnation properties, and ink permeability, allowing gas and liquid to permeate or pass through. The fiber paper with a thickness of 5 $\mu$m or more can maintain its strength. A thickness not more than 200 $\mu$m ensures not only good flexibility and processability, but also excellent impregnation properties and permeability of gas and liquid. In addition, if the thickness is not more than 200 $\mu$m, heat is sufficiently transferred inside the fiber paper and allows fibers inside the fiber paper to be sufficiently fused during heat-pressing, thereby providing the fiber paper with sufficient strength.

It is preferable that the fiber paper core material for a printed wiring board of the invention also has a thickness of 5 to 200 $\mu$m, more preferably from 5 to 100 $\mu$m, more preferably from 5 to 90 $\mu$m, more preferably from 5 to 50 $\mu$m, more preferably from 5 to 40 $\mu$m, more preferably from 5 to 20 $\mu$m, and still more preferably from 5 to 15 $\mu$m.

The fiber paper of the present invention preferably has a void ratio shown by the following formula of 30 to 90%.

$$\text{Void ratio} = (1 - \text{total mass of fibers forming the fiber paper/density of the}$$

$$\text{fibers/(thickness of fiber paper} \times \text{area of fiber paper)}) \times 100$$

A more preferable void ratio is 35 to 85%. A void ratio between 30 to 90% ensures lightness, porosity, processability, impregnation property, and other characteristics of fiber paper. A void ratio of 30% or more can provide light and porous properties characteristic to fiber paper. A void ratio of 90% or less can provide strength necessary for fiber paper.

The strength per unit mass of the fiber paper of the present invention, that is, the strength per unit thickness and unit basis weight (= tensile strength/thickness/basis weight) is preferably 100 MN/kg or more, more preferably 200 MN/kg or more, more preferably 400 MN/kg or more, more preferably 700 MN/kg or more, more preferably 1,000 MN/kg or more, more preferably 1,500 MN/kg or more, still more preferably 2,000 MN/kg or more, and particularly preferably 2,500 MN/kg or more. A tough fiber paper having strength necessary for processing and handling in spite of its lightness and thinness can be obtained by making the strength per unit mass 100 MN/kg or more.

The aliphatic polyketone fibers used in the present invention have a structure comprising 90 mol% by mass or more of the repeating unit of the following formula (1).

$$-CH_2-CH_2-CO- \qquad (1)$$

If the content of the repeating unit is 90 mol% or more, the fiber paper has high strength and modulus of elasticity and excellent heat resistance.

Crystallinity of the fiber is preferably 30% or more. A crystallinity of 30% or more ensures that the fiber paper exhibits high strength and high modulus of elasticity.

As a process for producing polyketone fibers, a process comprising wet-spinning the fibers from an aqueous solution of a polyketone using a zinc salt, a calcium salt, an isocyanate salt, or the like, followed by heat-drawing the fibers as described in Patent Document 3 is preferable for obtaining polyketone fibers having high strength and high modulus of elasticity.

The aliphatic polyketone fibers used in the present invention are preferably staple fibers having an average fiber length of 0.5 to 10 mm, and more preferably 1 to 7 mm. Cut staple fibers are preferably used. Staple fibers with a fiber length of 0.5 mm or more can ensure necessary paper strength during the paper making process. Staple fibers with a fiber length of not more than 10 mm can improve the homogeneity of the fiber dispersion during the paper making process.

The aliphatic polyketone fibers used in the present invention preferably have an average fiber diameter of 20 $\mu$m or less in order to produce uniform and thin fiber paper. A more preferable average fiber diameter is 17 $\mu$m or less. In addition, in order to maintain strength during the thermal fusion of sheets, the average fiber diameter is preferably 0.1 $\mu$m or more, and more preferably 1 $\mu$m or more.

It is preferable to blend 1 to 100% by mass of the polyketone fibers of the present invention with 99 to 0% by mass of other fibers. A more preferable amount of the polyketone fibers is 100% by mass or 1 to 99% by mass. A still more preferable amount of the polyketone fibers is 1 to 99% by mass or 100% by mass. The lower limit of the amount of the polyketone fiber is more preferably 10% by mass, more preferably 50% by mass, more preferably 60% by mass, more preferably 70% by mass, and still more preferably 80% by mass. The amount of 1% by mass or more ensures the product to exhibit high strength and high heat resistance of polyketone fibers. The fiber paper is provided with properties peculiar to polyketone fibers when the amount is 100% by mass, and with properties peculiar to the other fibers when the amount is 99% by mass or less.

As examples of the other fibers used in the present invention, natural fibers, regenerated natural fibers, inorganic fibers, and/or synthetic fibers can be given. Cellulose fibers such as cotton, hemp, and wood can be given as examples of the natural fibers. As examples of the regenerated natural fibers, viscose fibers, rayon fibers, and solvent-spun cellulose fibers can be given. As examples of the inorganic fibers, glass fibers, carbon fibers, and metal fibers can be given. As examples of the synthetic fibers, polyethylenes, polypropylenes, nylons, polyesters, and polyacrylonitriles can be given. Heat resistance can be improved particularly by using synthetic heat resistant fibers such as wholly aromatic polyamide fibers (p-phenyleneterephtalamide fibers and p-phenylenediphenyl ether terephtalamide fibers (these are hereafter called "para-aramid fibers")), wholly aromatic polyester fibers, poly(p-phenylenebenzobisoxazole) (PBO) fibers, polyimide fibers, polyphenylene sulfide fibers, and Teflon™ fibers. Either one of these other fibers or a combination of two or more of these other fibers can be mixed with the polyketone fiber to obtain a fiber paper possessing properties of these other fibers. The fiber length of these other fibers is the same as the length of the polyketone fibers, that is, preferably 0.5 to 10 mm. The average fiber diameter is preferably 0.1 to 20 $\mu$m.

The polyketone fiber paper of the present invention can be produced by a wet paper making process comprising homogeneously dispersing 100% by mass of the polyketone fibers or a mixture of 1 to 99% by mass of the polyketone fibers and 99 to 1% by mass of the other fibers in water using a pulper, processing the dispersion liquid by a cylinder paper machine, a Fourdrinier paper machine, an inclined-wire former, or a combination paper-making machine of these machines, thereby forming a plane paper layer in which fibers are uniformly distributed on a net, sufficiently drying the paper by a drier such as a drum dryer, a Yankee dryer, or a hot-blast dryer, and hot-pressing the dried paper to cause the polyketone fibers to be fused among themselves or with other fibers, thereby causing the paper to exhibit the target strength.

This is a typical process for producing the fiber paper, but the process is by no means limited to the above-described process. For example, when 1 to 99% by mass of the polyketone fibers is mixed with 99 to 1% by mass of the other fibers, these fibers may be mixed using a pulper while deflaking or may be separately deflaked before being mixed. When fibers are dispersed in water, additives such as an emulsifier, a dispersant, a viscosity controlling agent, and/or a paper-reinforcing agent may be added to improve dispersibility, whereby a thinner and more uniform fiber paper with an adequate strength can be obtained. The addition of additives by no means provides limitations to the present invention. Furthermore, the whole or a part of the polyketone fibers may be refined to become fibrillated before paper-making, the whole or a part of the other fibers may be mixed after refining and fibrillation, or the polyketone fibers and other fibers are refined after mixing. Refining makes fiber layers uniform, increases the strength of paper layers, increases the production speed, improves productivity, and ensures production of thinner and more uniform fiber paper possessing increased strength. The refining may be carried out using a device called a beater or may be carried out using a disc refiner, a high-pressure homogenizer, or the like. In order to produce a thinner fiber paper possessing more uniform strength, it is preferable that fibers are preliminarily refined using a beater or a disc refiner, followed by fibrillation using a high-pressure homogenizer to decrease the fiber diameter. In order to produce a thinner fiber paper possessing more uniform strength, preliminary refining is preferably carried out for 1 to 4 hours using a beater. It is preferable to circulate the fibers 10 to 200 times in a disc refiner, followed by crushing by circulating 5 to 50 times using a high-pressure homogenizer under a pressure of 100 Mpa. Freeness after refining is preferably 20 to 50°SR, and more preferably 25 to 45°SR. The freeness is determined using a Schopper Riegler freeness tester according to JIS-P8121 by diluting the fibers with water to a fiber concentration of 0.2% by mass. The average of two measurements is used as the value of freeness. Since the number of fibers in the fiber paper thickness direction is increased by highly fibrillating the fibers and decreasing the fiber diameter, it is possible to obtain a thinner and more uniform fiber paper by fibrillating the fibers and decreasing the fiber diameter. A high degree of fibrillation and miniaturization of the fiber diameter can increase contact points among fibers and increase the strength after thermal fusion. Provision of the step of refining by no means limits the present invention. Furthermore, it is possible to previously make a 100% by mass polyketone fiber paper and form a paper of other fibers on the 100% by mass polyketone fiber paper, or to form a paper of other fibers on both sides of the 100% by mass polyketone fiber paper. The step of the process may be reversed. There are no specific limitations to the process of making paper.

The fiber paper with a high strength per unit mass of the present invention can only be obtained by thermally fusing fibers of a light, thin, and uniform fiber paper. In order to thermally fuse the whole or a part of the aliphatic polyketone fibers among themselves or with other fibers, it is preferable to heat-press the fibers at a temperature in the range from 40 degrees lower to 40 degrees higher than the melting point of the polyketone fiber. The polyketone fibers are thermally fused by heat-pressing at a temperature of 40 degrees lower than the melting point or over. Heat-pressing at a temperature of 40 degrees higher than the melting point or below is preferable, because the fibers are neither molten nor baked in this temperature range. When the melting point of other fibers is lower than that of the melting point of the polyketone fibers, the polyketone fibers and still other fibers may be thermally fused using such other fibers. In this instance the other fibers are preferably heat-pressed at a temperature in the range from 40 degrees lower to 40 degrees higher than the melting point of such other fibers. Although a commonly used press linear load is applied during the heat press, a linear load in the range from 1 to 200 kN/m is preferable in order to control the thickness.

To further increase the strength or to provide the polyketone fiber paper core material for a printed wiring board with processability and other functions, the polyketone fiber paper and the polyketone fiber paper core material for a printed wiring board of the present invention can be impregnated or coated with the same or different polymer resin, such as a thermoplastic resin or a thermoset resin, as used when producing a printed wiring board.

The polyketone fiber paper and the polyketone fiber paper core material for a printed wiring board of the present invention can be used as a printed wiring board in a single layer or multiple layers. When a thin polyketone fiber paper is used in multiple layers, the multilayer fiber paper exhibits greater strength than a single layer fiber paper made from the same fiber and having the same void ratio and the same thickness. Such a material can be used as a high strength printed wiring board or in other applications as a high-strength resin-impregnated board.

The printed wiring board of the present invention is prepared by impregnating or coating the aliphatic polyketone fiber paper core material comprising 1 to 100% by mass of aliphatic polyketone fibers with a polymer resin. Due to the low dielectric properties of the polyketone fiber paper core material, the substrate is provided with excellent electrical characteristics such as a low dielectric constant and a low dielectric loss tangent.

As examples of the polymer resins used in the present invention, thermoplastic resins such as a polyolefin resin and a fluororesin, and thermoset resins such as a phenol resin, an epoxy resin, and a polyimide resin can be given. In particular, if a low dielectric polymer resin having a dielectric constant of 4.0 or less such as a polyolefin resin, a polystyrene resin, a fluororesin, a silicon resin, a polyimide resin, an epoxy resin, and particularly a polyphenylene ether epoxy resin (a resin containing polyphenylene ether substituted with or containing an epoxy group in an average amount of one or more per molecule and at least one curing agent selected from the group consisting of an amine, a novolak phenol, and an acid anhydride as essential components), is used, the substrate exhibits very excellent electrical characteristics, along with the low dielectric properties of the polyketone fiber paper core material. Such a substrate can be suitable as a substrate for high frequency circuits.

The printed wiring board of the present invention can be prepared by melting a polymer resin or diluting the polymer resin with a solvent to fluidize the resin, impregnating the polyketone fiber paper core material with the melted or fluidized polymer resin, and cooling or drying the resin. In the case of a thermoset resin, the resin may be cured after further heating to the curing temperature. It is possible to press the printed wiring board in order to adjust the thickness. There are no limitations to the method for preparing the printed wiring board of the present invention.

The printed wiring board of the present invention may be used for an application in which a single-layer substrate is used. Furthermore, making the best use of the thinness, the core material can be used for an application of forming a laminated board by heat-pressing or an application of forming an insulating layer or a multilayer printed wiring board in the multilayer printed wiring board in which the printed wiring is provided in an inner layer and a surface layer across the insulating layer.

EXAMPLES

The present invention will be described in more detail by examples, which should not be construed as limiting the present invention.

The type, form, and the like of the fibers used for the polyketone fiber papers and polyketone fiber paper core materials for a printed wiring board are shown in Table 1, and the constitution and the measurement results of the properties of the polyketone fiber papers and the polyketone fiber paper core materials for a printed wiring board are shown in Table 2. The measurement results of the properties of the printed wiring boards in which the core materials are used are also shown in Table 2.

The polyketone fibers shown in Table 1 comprise substantially 100mol% of the repeating unit of the below-mentioned formula (1). Fibers A6 and A7 in Table 1 were refined by circulating a water dispersion with a fiber concentration of 1% by mass, to which the defoamer (as described in Example 1) has been added, 30 times in a disc refiner (manufactured by Kumagai Riki Kogyo Co., Ltd.) in which the disc interval is adjusted to 0.2 mm, then adjusting the fiber concentration of the water dispersion to 0.75% by mass, and circulating this water dispersion 10 times (in the case of Fiber A) or 20 times (in the case of Fiber B) in a high-pressure homogenizer (manufactured by Niro Soavi S. p. A.) under the conditions of pressure 100 MPa. Fiber F in Table 1 was refined by circulating a water dispersion of a solvent-spun cellulose fiber (TENCEL™ manufactured by Courtaulds Fibers, Inc.) 30 times in the disc refiner and 5 times in the high-pressure homogenizer in the same manner.

$$-CH_2-CH_2-CO- \qquad (1)$$

(Example 1)

100% by mass of aliphatic polyketone staple fibers with an average fiber diameter of 10 $\mu$m and fiber length of 3 mm were charged to a pulper, followed by the addition of water warmed to 50°C, to obtain a polyketone staple fiber water dispersion (fiber concentration: 2% by mass). The dispersion liquid was stirred for 15 minutes. Water was added to the dispersion liquid to make the fiber concentration 1% by mass. A defoamer (polyoxyalkylene glycol fatty acid ester) was added in an amount of 0.5% by mass of the amount of fibers, and the mixture was stirred for 30 minutes in a low-speed stirring vessel. Water was further added to the fiber dispersion liquid to adjust the slurry concentration to 0.1% by mass, followed by the addition of 20 ppm of a viscosity controlling agent (polyethylene oxide). The resulting slurry was deaerated under vacuum immediately before making paper using a cylinder paper machine equipped with a 100 mesh wire at a rate of 30 m/min. The wet paper thus produced was dried using a Yankee drier at a surface temperature of 130°C and pressed using a hot roller at a surface temperature of 275°C to obtain a polyketone fiber paper with a thickness of 50 $\mu$m and a void ratio of 70%.

The fiber paper was stored at a temperature at which cellulose decomposes (230°C) for three hours. Neither the color nor the size changed, demonstrating excellent heat resistance and dimensional stability. In addition, the fiber paper did not change after being dipped in 40% sulfuric acid, a 40% aqueous solution of sodium hydroxide, or hexane at room temperature for 10 days, showing excellent chemical resistance. Moreover, water absorption of the fiber paper after storing at 23°C and 80% RH for three days was less than 1% by mass, demonstrating low water absorptivity.

The fiber paper, as a polyketone fiber paper core material for a printed wiring board, was immersed in an epoxy resin solution (bisphenol A epoxy resin: 75 parts by mass, high brominated bisphenol A epoxy resin: 25 parts by mass, and dicyandiamide curing agent: 3 parts by mass) with a solid component concentration of 45%. The supporting body was removed from the epoxy resin solution, dried and half-cured at 160°C, and pressed and cured at 185°C to obtain a flat board with a smooth surface. (Examples 2 to 9)
Polyketone fiber papers and polyketone fiber paper core materials for a printed wiring board were prepared in the same manner as in Example 1 using the aliphatic polyketone fibers shown in Table 2. Conditions differing from the conditions of Example 1 are described in Table 2. Printed wiring boards were prepared in the same manner as in Example 1 using the core materials. (Example 10)
Printed wiring boards were prepared in the same manner as in Example 1 by immersing the polyketone fiber paper core materials for a printed wiring board prepared in Example 1 in an epoxy resin solution (polyphenylene ether-based epoxy resin: 100 parts by mass, dicyandiamide curing agent: 3 parts by mass) with a solid component content of 45%.

(Examples 11 to 15)

Polyketone fiber papers and polyketone fiber paper core materials for a printed wiring board were prepared in the same manner as in Example 1 using the aliphatic polyketone fibers shown in Table 2. Conditions differing from the conditions of Example 1 are described in Table 2. Printed wiring boards were prepared in the same manner as in Example 10 using the core materials.

(Example 16)

A defoamer was added to a mixture of 70% by mass of aliphatic polyketone staple fibers with an average fiber diameter of 10 $\mu$m and fiber length of 3 mm and 30% by mass of para-aramid fibers (Technora™ manufactured by Teijin, Ltd.) with a fiber length of 3 mm. The mixture was charged to a pulper and dispersed in water to obtain a fiber dispersion liquid. A viscosity controlling agent was added to the fiber dispersion liquid and the mixture was deaerated under vacuum immediately before making paper using a cylinder paper machine equipped with a 100 mesh wire. The resulting paper was dried using a Yankee drier at a surface temperature of 130°C and pressed using a hot roller at a surface temperature of 275°C to obtain a polyketone fiber paper with a thickness of 50 $\mu$m and a void ratio of 70%.

The fiber paper was stored at a temperature at which cellulose decomposes (230°C) for three hours. Neither the color nor the size changed, demonstrating excellent heat resistance and dimensional stability. In addition, the fiber paper did not change after being dipped in 40% sulfuric acid, a 40% aqueous solution of sodium hydroxide, or hexane at room temperature for one day, showing excellent chemical resistance. Moreover, water absorption of the fiber paper after storing at 23°C and 80% RH for three days was 1% by mass, demonstrating low water absorptivity.

A substrate was prepared in the same manner as in Example 1 using this fiber paper as a polyketone fiber paper core material for a printed wiring board.

(Examples 17 to 27)

Polyketone fiber papers and polyketone fiber paper core materials for a printed wiring board were prepared in the same manner as in Example 1 using the aliphatic polyketone fibers and other fibers shown in Table 2. Conditions differing from the conditions of Example 1 are described in Table 2. Printed wiring boards were prepared in the same manner as in Example 1 using the core materials.

(Example 28)

A printed wiring board was prepared in the same manner as in Example 1 by immersing the polyketone fiber paper core material for a printed wiring board prepared in Example 16 in an epoxy resin solution (polyphenylene ether epoxy resin: 100 parts by mass, dicyandiamide curing agent: 3 parts by mass) with a solid component content of 45%.

Comparative Examples 1 to 2

A defoamer was added respectively to glass fibers with an average fiber diameter of 12 μm and fiber length of 3 mm and to para-aramid fibers. The fibers were each dispersed in water using a pulper to obtain fiber dispersion liquids. After the addition of a viscosity controlling agent, each of the fiber dispersion liquids was deaerated under vacuum immediately before making paper using a cylinder paper machine equipped with a 100 mesh wire. The resulting papers were dried using a Yankee drier at a surface temperature of 130°C installed with a heat press roller of which the temperature was set at the upper limit of 350°C. Neither the glass fibers nor the para-aramid fibers reached the respective softening temperature, thus failing to exhibit fiber paper strength. Therefore, after moving onto a polytetrafluoroethylene sheet, the fiber papers were impregnated with the same epoxy resin solution as used in Example 1 to obtain printed wiring boards under the same conditions as in Example 1.

The glass fibers and para-aramid fibers were stored for three hours at a temperature at which cellulose decomposes (230°C). Neither the color nor the size changed, demonstrating excellent heat resistance and dimensional stability. As a result of immersion in 40% sulfuric acid, a 40% aqueous solution of sodium hydroxide, and hexane at room temperature for 10 days, the glass fibers and para-aramid fibers were found to have been damaged by the aqueous solution of sodium hydroxide. In addition, the glass fibers and para-aramid fibers were stored under the conditions of a temperature of 23°C and RH of 80% for three days to confirm that the water adsorption of the glass fibers was less than 1% by mass and that of the para-aramid fibers was 4% by mass.

Comparative Example 3

A fiber paper was obtained using polyethylene terephthalate (polyester) fibers (EPO43™ manufactured by Kuraray Co., Ltd.) according to the same method as used in Example 1.
Although the resulting fiber paper exhibited low water absorptivity, the fiber paper was deformed in the heat resistance test and dimensional stability test, and was damaged by a 40% aqueous solution of sodium hydroxide in the chemical resistance test.
A printed wiring board was prepared in the same manner as in Example 1 using the fiber paper as a core material for a printed wiring board.

(Comparative Example 4)

A defoamer was added to a mixture of 50% by mass of para-aramid fiber with an average fiber diameter of 12 μm and fiber length of 3 mm and 50% by mass of PBO fibers (ZYLON AS™ manufactured by Toyobo Co., Ltd.). The mixture was dispersed in water using a pulper to obtain a fiber dispersion liquid. After the addition of a viscosity controlling agent, the fiber dispersion liquid was deaerated under vacuum immediately before making paper using a cylinder paper machine equipped with a 100 mesh wire. The resulting paper was dried using a Yankee drier at a surface temperature of 130°C installed with a heat press roller of which the temperature was set at the upper limit of 350°C. Neither the para-aramid fibers nor the PBO fibers reached the respective softening temperature, thus failing to exhibit strength of a fiber paper. Therefore, after moving onto a polytetrafluoroethylene sheet, the fiber paper was impregnated with the same epoxy resin solution used in Example 1 to obtain a printed wiring board under the same conditions as in Example 1.

(Comparative Examples 5 to 7)

Core materials for a printed wiring board were prepared in the same manner as in Example 1 by combining the other fibers shown in Table 2. Conditions differing from the conditions of Example 1 are described in Table 2. Printed wiring boards were prepared in the same manner as in Example 1 using the core materials.

The fiber papers and the fiber paper core materials for a printed wiring board prepared in Examples 1 to 28 and Comparative Examples 1 to 7 were evaluated by the following methods.

Tensile strength: Test specimens with a width of 15 mm and a length of 100 mm were elongated using a constant speed drawing tensile tester at an elongation rate of 300 mm/min to determine the maximum load up to the point of breaking. The average of five measurements was regarded as the tensile strength (kN/m).

Thickness unevenness: The thickness was measured at ten arbitrary points using a micrometer to calculate the rate of thickness change. Samples with a rate of thickness change of less than 10% were evaluated as "O", those with a rate of thickness change of 10 to 20% were evaluated as "Δ", and those with a rate of thickness change of 20% or more were evaluated as "X".

$$\text{Rate of thickness change} = (\text{maximum measured thickness} - \text{minimum measured thickness})/\text{average measured thickness} \times 100$$

The printed wiring boards prepared from the fiber paper core materials prepared above were evaluated and compared by the following methods.

Smoothness: The mirror reflection light on the surface of the substrate was visually observed. The samples of which the reflection light was uniform were evaluated as "O", otherwise the samples were evaluated as "X".

Heat resistance: The printed wiring boards were stored for three days under an atmosphere of 30°C and 80% RH, then immersed in a molten solder bath at 260°C for two minutes to visually observe the change of state. The samples with no change being observed were evaluated as "O", otherwise the samples were evaluated as "X".

Half-cured printed wiring boards obtained above were laminated and heat-pressed at 185°C to obtain laminated boards with a thickness of 1 mm. The laminated boards were stored under an atmosphere of 23°C and 65% RH for one day and the following evaluations were carried out.

Dielectric constant: A copper foil was applied to both sides of the substrate to measure the dielectric constant of the substrate as an electrode using a dielectric property meter manufactured by Agilent Technologies, Inc. (Type 4284™). A frequency of 1 MHz was used for the measurement.

Dimensional stability: The coefficient of thermal expansion in the XY direction of a test specimen was measured using a linear expansion measuring device when the temperature was increased from 100°C to 200°C. Samples were evaluated as "O" when the coefficient of thermal expansion was 10 ppm/°C or less, as "Δ" when the coefficient of thermal expansion was 10 to 20 ppm/°C, and as "X" when the coefficient of thermal expansion was 20 ppm/°C or more.

TABLE 1

|  | Name of fiber | Fiber length (mm) | Average fiber diameter (μm) | Refining | Freeness (°SR) |
|---|---|---|---|---|---|
| Fiber A1 | Polyketon fiber | 3 | 10 | No | ≤10 |
| FiberA2 | Polyketon fiber | 1 | 10 | No | ≤10 |
| Fiber A3 | Polyketon fiber | 5 | 10 | No | ≤10 |
| Fiber A4 | Polyketon fiber | 7 | 10 | No | ≤10 |
| Fiber A5 | Polyketon fiber | 2 | 15 | No | ≤10 |
| Fiber A6 | Polyketon fiber | 2 | 6 | Yes | 26 |
| Fiber A7 | Polyketon fiber | 2 | 3 | Yes | 43 |
| Fiber A8 | Polyketon fiber | 15 | 15 | No | ≤10 |
| Fiber A9 | Polyketon fiber | 5 | 25 | No | ≤10 |
| Fiber B | Glass fiber | 3 | 12 | No | ≤10 |
| Fiber C | Para-aramid fiber | 3 | 12 | No | ≤10 |
| Fiber D | PBO fiber | 3 | 12 | No | ≤10 |

(continued)

|  | Name of fiber | Fiber length (mm) | Average fiber diameter ($\mu$m) | Refining | Freeness (°SR) |
|---|---|---|---|---|---|
| Fiber E | Polyester fiber | 3 | 8 | No | ≤10 |
| Fiber F | Solvent-spun cellulose fiber | - | - | Yes | 60 |

TABLE 2

| | | Fiber paper and core material | | | | | | | | | | Wiring board | | | | |
| | | Mixture (% by mass) | | | Heat-pressing temperature (°C) | Heat-pressing linear load (kN/m) | Basis weight (g/m²) | Thickness (μm) | Thickness unevenness | Void ratio (%) | Tensile strength (kN/m) | Strength per unit mass (MN/kg) | Thickness (μm) | Smoothness | Heat resistance | Dielectric constant | Dimensional stability |
| | | Fiber 1 | Fiber 2 | Fiber 3 | | | | | | | | | | | | | |
| Example | 1 | A1 (100) | | | 275 | 100 | 20 | 50 | O | 70 | 0.39 | 390 | 60 | O | O | 3.7 | O |
| | 2 | A2 (100) | | | 265 | 70 | 20 | 67 | O | 77 | 0.35 | 261 | 75 | O | O | 3.7 | O |
| | 3 | A3 (100) | | | 267 | 200 | 30 | 76 | O | 70 | 0.62 | 272 | 85 | O | O | 3.7 | O |
| | 4 | A4 (100) | | | 270 | 200 | 30 | 68 | O | 66 | 0.57 | 279 | 80 | O | O | 3.6 | O |
| | 5 | A5 (100) | | | 265 | 70 | 50 | 156 | O | 75 | 0.90 | 115 | 160 | O | O | 3.7 | O |
| | 6 | A6 (100) | | | 267 | 70 | 40 | 80 | O | 62 | 0.88 | 275 | 90 | O | O | 3.6 | O |
| | 7 | A7 (100) | | | 270 | 200 | 7 | 11 | O | 51 | 0.22 | 2857 | 15 | O | O | 3.6 | O |
| | 8 | A8 (100) | | | 270 | 100 | 30 | 80 | Δ | 71 | 0.59 | 246 | 90 | Δ | O | 3.7 | O |
| | 9 | A9 (100) | | | 265 | 70 | 30 | 240 | Δ | 92 | 0.10 | 14 | 250 | Δ | O | 3.9 | Δ |
| | 10 | A1 (100) | | | 275 | 100 | 20 | 50 | O | 70 | 0.39 | 390 | 60 | O | O | 3.3 | O |
| | 11 | A7 (100) | | | 267 | 100 | 8 | 19 | O | 68 | 0.24 | 1579 | 30 | O | O | 3.3 | O |
| | 12 | A7 (100) | | | 267 | 70 | 12 | 28 | O | 67 | 0.34 | 1012 | 40 | O | O | 3.3 | O |
| | 13 | A6 (100) | | | 267 | 70 | 20 | 47 | O | 67 | 0.52 | 553 | 60 | O | O | 3.3 | O |
| | 14 | A1 (100) | | | 265 | 70 | 40 | 96 | O | 68 | 0.72 | 188 | 120 | O | O | 3.3 | O |
| | 15 | A1 (100) | | | 260 | 50 | 80 | 210 | Δ | 71 | 1.18 | 70 | 230 | Δ | O | 3.3 | O |
| | 16 | A1 (70) | C (30) | | 275 | 100 | 20 | 60 | O | 74 | 0.36 | 300 | 75 | O | O | 3.7 | O |
| | 17 | A2 (80) | C (20) | | 265 | 70 | 30 | 120 | O | 81 | 0.60 | 167 | 140 | O | O | 3.7 | O |
| | 18 | A3 (20) | D (80) | | 270 | 100 | 40 | 144 | O | 79 | 0.26 | 45 | 160 | O | O | 3.9 | O |
| | 19 | A4 (50) | D (50) | | 265 | 100 | 20 | 73 | O | 79 | 0.29 | 199 | 90 | O | O | 3.8 | O |
| | 20 | A5 (80) | E (20) | | 265 | 200 | 30 | 42 | O | 45 | 0.70 | 556 | 55 | O | O | 3.7 | O |
| | 21 | A5 (70) | E (30) | | 265 | 200 | 40 | 95 | O | 68 | 0.75 | 197 | 110 | O | O | 3.7 | O |
| | 22 | A6 (80) | F (20) | | 270 | 100 | 7 | 15 | O | 63 | 0.29 | 2762 | 25 | O | O | 3.7 | O |
| | 23 | A7 (60) | F (40) | | 270 | 100 | 30 | 55 | O | 55 | 0.52 | 315 | 70 | O | O | 3.8 | O |
| | 24 | A1 (40) | C (40) | E (20) | 265 | 200 | 40 | 106 | O | 71 | 0.44 | 104 | 130 | O | O | 3.8 | O |
| | 25 | A1 (50) | A6 (30) | F (20) | 270 | 100 | 20 | 56 | O | 73 | 0.62 | 554 | 70 | O | O | 3.7 | O |
| | 26 | A8 (70) | D (30) | | 270 | 70 | 30 | 133 | Δ | 83 | 0.10 | 25 | 150 | Δ | O | 3.7 | O |
| | 27 | A9 (80) | E (20) | | 265 | 70 | 30 | 240 | Δ | 91 | 0.13 | 18 | 270 | Δ | O | 3.9 | Δ |
| | 28 | A1 (70) | C (30) | | 275 | 100 | 20 | 60 | O | 74 | 0.36 | 300 | 75 | O | O | 3.4 | O |
| Comparative Example | 1 | B (100) | | | 350 | 200 | 60 | - | - | - | did not exhibit strength | | 80 | O | O | 4.4 | Δ |
| | 2 | C (100) | | | 350 | 200 | 30 | - | - | - | did not exhibit strength | | 90 | O | X | 4.1 | O |
| | 3 | E (100) | | | 235 | 50 | 30 | 80 | O | 71 | 0.35 | 146 | 90 | O | X | 4.0 | X |
| | 4 | C (50) | D (50) | | 350 | 200 | 20 | - | - | - | did not exhibit strength | | 90 | × | X | 4.1 | O |
| | 5 | C (50) | E (50) | | 235 | 50 | 20 | 65 | O | 76 | 0.16 | 123 | 80 | O | X | 4.1 | X |
| | 6 | D (50) | F (50) | | - | - | 20 | 55 | O | 68 | 0.18 | 164 | 70 | O | X | 4.5 | Δ |
| | 7 | E (50) | F (50) | | 235 | 100 | 20 | 50 | O | 65 | 0.19 | 190 | 65 | O | X | 4.5 | X |

INDUSTRIAL APPLICABILITY

The polyketone fiber paper of the present invention can be suitably used for applications such as a core material for a printed wiring board; an electrode separator or a separator core material for a condenser such as an aluminum electrolytic condenser or an electrical double layer capacitor; an electrode separator or a separator core material for a cell such as a fuel cell, a lithium ion battery, or a nickel-hydrogen battery; and a core material for an ion exchange membrane.

The polyketone fiber paper core material for a printed wiring board and the printed wiring board using the core material are particularly suitable for a printed wiring board for electrical equipment, in particular, for use in a multilayer printed wiring board and the like because of the thinness of the core material. Moreover, the polyketone fiber paper core material for a printed wiring board and the printed wiring board using the core material can be suitably used for a printed wiring board for a high frequency circuit and the like because of the low dielectricity.

**Claims**

1.  A polyketone fiber paper comprising 1 to 100% by mass of aliphatic polyketone fibers which comprise the repeating unit of the following formula (1), wherein the polyketone fiber paper is produced by a wet process.

    $-CH_2-CH_2-CO-$ (1)

2.  A polyketone fiber paper comprising 1 to 99% by mass of aliphatic polyketone fibers which comprise the repeating unit of the following formula (1), wherein the polyketone fiber paper is produced by a wet process.

    $-CH_2-CH_2-CO-$ (1)

3.  A polyketone fiber paper comprising aliphatic polyketone fibers which comprise the repeating unit of the following formula (1), wherein the polyketone fiber paper is produced by a wet process.

    $-CH_2-CH_2-CO-$ (1)

4.  The polyketone fiber paper according to any one of claims 1 to 3, having a thickness of 5 to 200 $\mu$m.

5.  The polyketone fiber paper according to any one of claims 1 to 3, having a thickness of 5 to 100 $\mu$m.

6.  The polyketone fiber paper according to any one of claims 1 to 3, having a thickness of 5 to 50 $\mu$m.

7.  The polyketone fiber paper according to any one of claims 1 to 6, having a void ratio shown by the following formula of 30 to 90%.

$$\text{Void ratio} = (1 - \text{total mass of fibers forming the fiber paper/density of the fibers/(thickness of fiber paper} \times \text{area of fiber paper)}) \times 100$$

8.  The polyketone fiber paper according to any one of claims 1 to 7, wherein the strength per unit mass of the fiber paper is 100 MN/kg or more, wherein the strength per unit mass is tensile strength/thickness/basis weight.

9.  The polyketone fiber paper according to any one of claims 1 to 7, wherein the strength per unit mass of the fiber paper is 200 MN/kg or more, wherein the strength per unit mass is tensile strength/thickness/basis weight.

10.  The polyketone fiber paper according to any one of claims 1 to 7, wherein the strength per unit mass of the fiber paper is 400 MN/kg or more, wherein the strength per unit mass is tensile strength/thickness/basis weight.

11.  The polyketone fiber paper according to any one of claims 1 to 10, wherein the polyketone fibers are staple fibers with an average fiber length of 0.5 to 10 mm.

12. The polyketone fiber paper according to any one of claims 1 to 11, wherein the polyketone fibers have an average diameter of 1 to 20 μm.

13. A polyketone fiber paper core material for a printed wiring board comprising the polyketone fiber papers according to any one of claims 1 to 12.

14. The polyketone fiber paper core material for a printed wiring board according to claim 13, wherein the polyketone fiber paper is used in a single layer or multiple layers.

15. A printed wiring board comprising the polyketone fiber paper core material according to claim 13 or 14 and a polymer resin.

16. The printed wiring board according to claim 15, wherein the polyketone fiber paper core material is impregnated or coated with the polymer resin.

17. The printed wiring board according to claim 15 or 16, wherein the polymer resin is a low dielectric polymer resin.

18. The printed wiring board according to any one of claims 15 to 17, wherein the polymer resin is a polyphenylene ether-based epoxy resin comprising polyphenylene ether substituted with or containing an epoxy group in an average amount of one or more per molecule and at least one curing agent selected from the group consisting of an amine, a novolak phenol, and an acid anhydride as essential components.

19. The printed wiring board according to any one of claims 15 to 18, wherein the printed wiring board is a single layer board or a multilayer board.

20. A method for producing an aliphatic polyketone fiber paper comprising preliminarily refining aliphatic polyketone fibers, crushing the refined aliphatic polyketone fibers, and making paper from the crushed aliphatic polyketone fibers.

21. The method for producing an aliphatic polyketone fiber paper according to claim 20, wherein the preliminary refining comprises a treatment using a beater or a refiner.

22. The method for producing an aliphatic polyketone fiber paper according to claim 20, wherein the crushing comprises a treatment using a high pressure homogenizer.

## INTERNATIONAL SEARCH REPORT

| International application No. |
|---|
| PCT/JP2006/300435 |

| A. CLASSIFICATION OF SUBJECT MATTER |
|---|
| *D21H13/22*(2006.01), *D01F6/76*(2006.01) |

According to International Patent Classification (IPC) or to both national classification and IPC

| B. FIELDS SEARCHED |
|---|

Minimum documentation searched (classification system followed by classification symbols)
*D21B1/00-1/38*(2006.01),*D21C1/00-11/14*(2006.01),*D21D1/00-99/00*(2006.01),
*D21F1/00-13/12*(2006.01), *D21G1/00-9/00*(2006.01),
*D21H11/00-27/42*(2006.01),*D21J1/00-7/00*(2006.01),*D01F1/00-6/96*(2006.01),
~~D01F9/00-9/04(2006.01)~~

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)
WPI

| C. DOCUMENTS CONSIDERED TO BE RELEVANT |
|---|

| Category* | Citation of document, with indication, where appropriate, of the relevant passages | Relevant to claim No. |
|---|---|---|
| X | JP 2001-207335 A  (Asahi Kasei Corp.), 03 August, 2001 (03.08.01), | 1-6,8-11, 13-17,19 |
| Y | Claims; Par. Nos. [0020], [0014], [0015], [0019] to [0021], [0023], [0035]; examples (Family: none) | 7,12,18, 20-22 |
| Y | JP 2002-302893 A  (Shin-Kobe Electric Machinery Co., Ltd.), 18 October, 2002 (18.10.02), Par. No. [0018] & US 2004/033746 A1     & WO 2002/025010 A1 | 7 |
| Y | JP 2002-138385 A  (Unitika Ltd.), 14 May, 2002 (14.05.02), Claims; Par. No. [0016] (Family: none) | 12 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 March, 2006 (15.03.06) | 28 March, 2006 (28.03.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
|---|
| PCT/JP2006/300435 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2001-192955 A  (Mitsubishi Paper Mills Ltd.),<br>17 July, 2001 (17.07.01),<br>Par. No. [0045]<br>(Family: none) | 18 |
| Y | JP 2000-017592 A  (Daicel Chemical Industries, Ltd.),<br>18 January, 2000 (18.01.00),<br>Claims; Par. Nos. [0011], [0019], [0023]<br>(Family: none) | 20-22 |
| Y | JP 2003-193387 A  (Daicel Chemical Industries, Ltd.),<br>09 July, 2003 (09.07.03),<br>Claims; Par. Nos. [0013], [0024]<br>(Family: none) | 20-22 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003171191 A
- JP H08190326 A
- JP 2001207335 A
- JP 2004010408 A